# EUROPEAN PATENT APPLICATION

(11) **EP 4 815 301 A1**
(43) Date of publication of application: **30.09.2026**
(21) Application number: 26163244.2
(22) Date of filing: 09.03.2026
(51) Int. Cl.: H03F 3/30

(54) **RING AMPLIFIER**

(30) Priority: 25.03.2025 US 202519089660
(71) Applicant: NXP USA, Inc, Austin, TX 78735 (US)
(72) Inventor: Berens, Michael Todd, 5656AG Eindhoven (NL)
(74) Representative: Schwarzweller, Thomas

(57) **Abstract**

A ring amplifier includes a first transistor having a gate coupled via a first capacitor to an output node of a first stage, and a current electrode coupled to the gate of the first transistor via a first switch and to a first output of a second stage. A second transistor has a current electrode coupled to the first output, and a gate coupled via a second capacitor to the output node and to a first bias via a second switch. A third transistor has a current electrode coupled to a second output of the second stage, and a gate coupled via a third capacitor to the output node and to a second bias via a third switch. A fourth transistor has a current electrode coupled to the second output, and a gate coupled via a fourth capacitor to the output and to the fourth transistor via a fourth switch.

## Description

### Background

### Field

This disclosure relates generally to integrated circuits, and more specifically, to a ring amplifier.

### Related Art

Amplifiers are commonly used in analog applications, such as in pipelined and successive-approximation-register pipelined (SAR-pipe) analog-to-digital converters (ADCs). However, as the required speeds increase, traditional amplifiers become overly costly and power hungry. Ring amplifiers are becoming more popular due to their higher speeds and efficiency as compared to traditional amplifiers. However, ring amplifiers typically lack robustness over process, voltage, and temperature (PVT) variations. Therefore, a need exists for a ring amplifier with improved robustness over PVT variations while capable of operating at higher speeds.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in schematic form, a ring amplifier in accordance with an embodiment of the present invention.
FIG. 2 illustrates, in schematic form, a bias generator for use in the ring amplifier of FIG. 1, in accordance with an embodiment of the present invention.
FIG. 3 illustrates a wave form of an example clock signal to control the ring amplifier of FIG. 1, in accordance with an embodiment of the present invention.
FIG. 4 illustrates, in schematic form, a common mode voltage circuit for use with the ring amplifier of FIG. 1, in accordance with an embodiment of the present invention.
FIG. 5 illustrates, in schematic form, a differential ring amplifier which is implemented using the ring amplifier of FIG. 1, in accordance with an embodiment of the present invention.

### Detailed Description

In one aspect, in order to obtain a ring amplifier that is more robust to PVT variations, the p-channel metal-oxide-semiconductor (PMOS)/ n-channel metal-oxide-semiconductor (NMOS) gates of the inverters in each stage of a ring amplifier are de-coupled. This allows independent bias control of each transistor. By being able to independently bias the PMOS and NMOS transistors, the ring amplifier results in optimal overdrive of the transistors while still creating an average dead-zone for stability. The dead-zone represents a voltage offset which allows for controlled amplification where the amplified output voltage becomes stable.

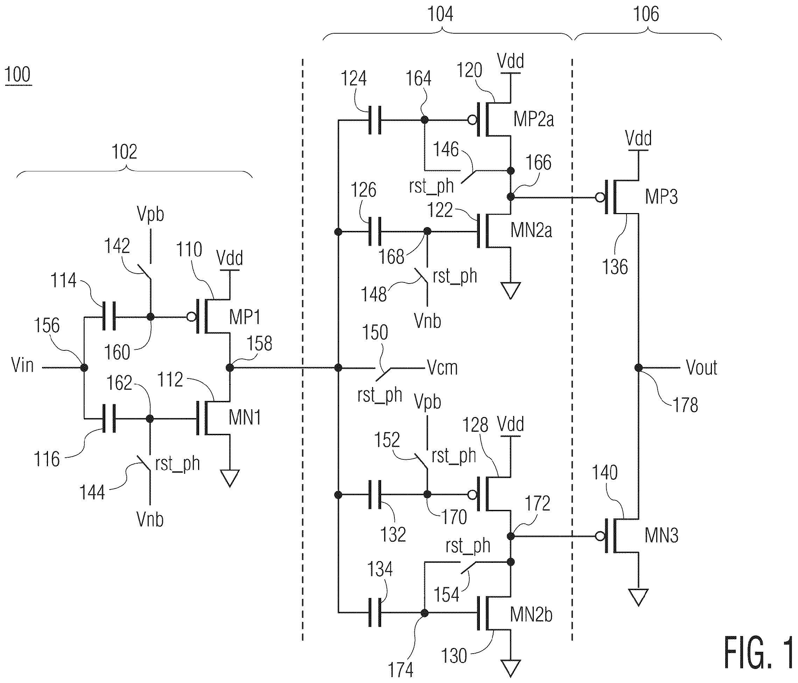

FIG. 1 illustrates, in schematic form, a ring amplifier 100, in accordance with an embodiment of the present invention. Ring amplifier 100 is coupled between a first power supply terminal configured to provide a first power supply voltage, Vdd, and a second power supply terminal configured to provide a second power supply voltage, Vss, which is less than Vdd. In one embodiment, Vss is ground or 0V. Note that, for ease of description, the power supply terminals may simply be referred to by the power supply voltages they provide (e.g. Vdd and Vss). Ring amplifier 100 is coupled to receive an input voltage, Vin, and provide an output voltage, Vout. Ring amplifier 100 includes three inverter stages (stages 102, 104, and 106). A first stage 102 is coupled to receive Vin at an input circuit node 156, and includes capacitive elements 114 and 116, a PMOS transistor 110 (labeled as MP1) and an NMOS transistor 112 (labeled as MN1), and switches 142 and 144. A second stage 104 has an input coupled to a circuit node 158, and includes capacitive elements 124, 126, 132, and 134, a PMOS transistor 120 (labeled as MP2a), an NMOS transistor 122 (labeled as MN2a), a PMOS transistor 128 (labeled as MP2b), an NMOS transistor 130 (labeled as MN2b), and switches 146, 148, 152, and 154. A third stage 106 includes a PMOS transistor 136 (labeled as MP3) and an NMOS transistor 140 (labeled as MN3), and provides Vout at an output circuit node 178. Note that, for ease of description, the transistors will be referred to by their labels rather than reference numerals (e.g. MP1, MN1, MP2a, MP1b, etc.), and capacitor elements will be referred to as capacitors but may each be formed by one or more capacitive elements.

In stage 102, a first terminal of capacitor 114 is coupled to input circuit node 156 and a second terminal of capacitor 114 is coupled to a circuit node 160. A first terminal of capacitor 116 is coupled to input circuit node 156 and a second terminal of capacitor 116 is coupled to a circuit node 162. A control electrode (e.g. gate) of MP1 is coupled to node 160, and a control electrode (e.g. gate) of MN1 is coupled to node 162. A first current electrode of MP1 is coupled to Vdd and a second current electrode is coupled to a circuit node 158, a first current electrode of MN1 is coupled to node 158, and a second current electrode of MN1 is coupled to Vss. A switch 142 has a first current electrode coupled to receive a first bias voltage, Vpb, a second current electrode coupled to node 160, and a control electrode coupled to receive a reset phase digital control signal, rst_ph. A switch 144 has a first current electrode coupled to receive a second bias voltage, Vnb, a second current electrode coupled to node 162, and a control electrode coupled to receive rst_ph. Note that each switch of ring amplifier 100 is controlled by rst_ph, in which the switch is closed (i.e. on or in the conductive state) when the value of rst_ph is a logic level one and open (i.e. off or in the non-conductive state) when the value of rst_ph is a logic level zero. Note that MP1 and MN1 correspond to a first inverter of stage 102 in which the inputs of this first inverter at the gates of MP1 and MN1 are de-coupled such that the gate of each of MP1 and MN1 is capacitively coupled to receive Vin via a corresponding capacitor, but the gates of MP1 and MN1 are not directly connected to each other, and circuit node 158 corresponds to an output of the first inverter of stage 102.

In stage 104, a first terminal of capacitor 124 is coupled to circuit node 158 and a second terminal of capacitor 124 is coupled to a circuit node 164. A first terminal of capacitor 126 is coupled to circuit node 158 and a second terminal of capacitor 126 is coupled to a circuit node 168. A control electrode (e.g. gate) of MP2a is coupled to node 164, and a control electrode (e.g. gate) of MN2a is coupled to node 168. A first current electrode of MP2a is coupled to Vdd and a second current electrode is coupled to a circuit node 166, a first current electrode of MN2a is coupled to node 166, and a second current electrode of MN2a is coupled to Vss. A switch 146 has a first current electrode coupled to node 164, a second current electrode coupled to node 166, and a control electrode coupled to receive rst_ph. A switch 148 has a first current electrode coupled to receive Vnb, a second current electrode coupled to node 168, and a control electrode coupled to receive rst_ph. A switch 150 has a first current electrode coupled to node 158, a second current electrode coupled to receive a common mode voltage, Vcm, and a control electrode coupled to receive rst_ph.

Continuing with stage 104, a first terminal of capacitor 134 is coupled to circuit node 158 and a second terminal of capacitor 134 is coupled to a circuit node 174. A first terminal of capacitor 132 is coupled to circuit node 158 and a second terminal of capacitor 132 is coupled to a circuit node 170. A control electrode (e.g. gate) of MP2b is coupled to node 170, and a control electrode (e.g. gate) of MN2b is coupled to node 174. A first current electrode of MP2b is coupled to Vdd and a second current electrode is coupled to a circuit node 172, a first current electrode of MN2b is coupled to node 172, and a second current electrode of MN2b is coupled to Vss. A switch 154 has a first current electrode coupled to node 174, a second current electrode coupled to node 172, and a control electrode coupled to receive rst_ph. A switch 152 has a first current electrode coupled to receive Vpb, a second current electrode coupled to node 170, and a control electrode coupled to receive rst_ph.

MP2a and MN2a correspond to a top inverter of stage 104 in which the inputs of this inverter at the gates of MP2a and MN2a are de-coupled such that the gate of each of MP2a and MN2a are capacitively coupled to node 158 (via capacitors 124 and 126, respectively), but the gates of MP2a and MN2a are not directly connected to each other, and an output of the this top inverter corresponds to a first output of stage 104 at node 166. MP2b and MN2b correspond to a bottom inverter of stage 104 in which the inputs of this inverter at the gates of MP2b and MN2b are de-coupled such that the gate of each of MP2b and MN2b are capacitively coupled to node 158 (via capacitors 132 and 134, respectively), but the gates of MP2b and MN2b are not directly connected to each other, and an output of the this bottom inverter corresponds to a second output of stage 104 at node 172. Note that the top and bottom inverters of stage 104 may also be referred to as the first and second inverters of stage 104. Note also that the switches of stages 102 and 104 may be implemented as known in the art, with any type of circuitry.

In stage 106, a first current electrode of MP3 is coupled to Vdd, a control electrode (e.g. gate) of MP3 is coupled to node 166 to receive the first output from stage 104, and a second current electrode of MP3 is coupled to node 178 which provides Vout. A first current electrode of MN3 is coupled to node 178, a control electrode (e.g. gate) of MN3 is coupled to node 172 to receive the second output from stage 104, and a second current electrode is coupled to Vss. MP3 and MN3 form an inverter of stage 106, in which an output of this inverter provides Vout at the output of ring amplifier 100.

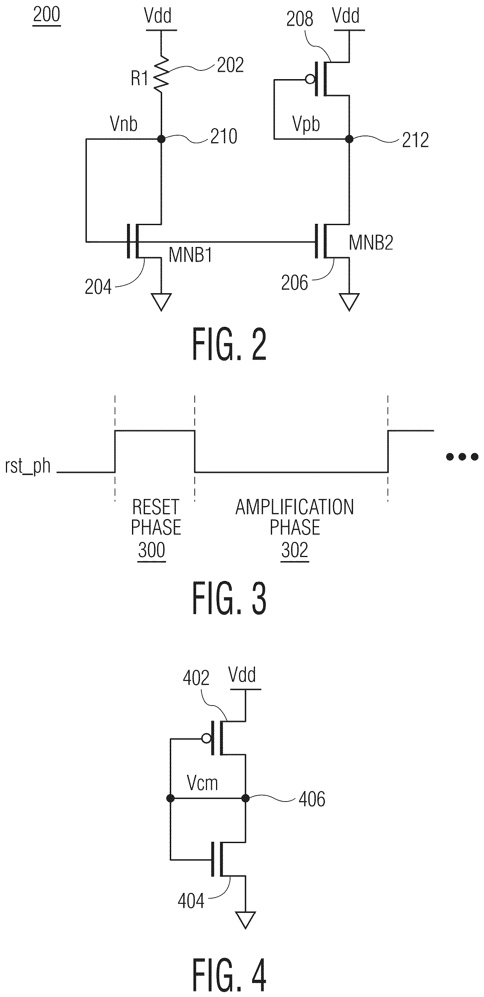

FIG. 2 illustrates, in schematic form, a bias generation circuit 200 configured to generate Vnb and Vpb, in accordance with one embodiment of the present invention. Bias generation circuit 200 includes a first current generator having a resistor element 202 (labeled as R1) and an NMOS transistor 204 (labeled as MNB1), and a second current generator having a PMOS transistor 208 (labeled as MPB) and an NMOS transistor 206 (labeled as MNB2). A first terminal of R1 is coupled to Vdd and a second terminal of R1 is coupled to a circuit node 210. A first current electrode of MNB1 and a control electrode (e.g. gate) of MNB1 are coupled to node 210. A second current electrode of MNB1 is coupled to Vss. A first current electrode of MPB is coupled to Vdd. A second current electrode of MPB and a control electrode (e.g. gate) of MPB are coupled to a circuit node 212. A first current electrode of MNB2 is coupled to node 212, a control electrode (e.g. gate) of MNB2 is coupled to circuit node 210, and a second current electrode of MNB2 is coupled to Vss. Node 210 is configured to provide Vnb, and node 212 is configured to provide Vpb.

Bias circuit 200 is formed by a pair of current sources in which Vnb at node 210 is generated using R1 to set current through MNB1 which is mirrored to MNB2. Vpb is then set by diode-connected MPB at node 212. In operation, during reset, the current in MPB is mirrored to MP1 and MP2b using voltage Vpb (while switches 142 and 152 are closed), and the current in MNB1 is mirrored to MN1 and MN2a (while switches 144 and 148 are closed). The transistor sizes of MPB and MP1 are ratiometric to each other so that their currents during reset will be proportional. Similarly, MNB1 and MN1 are ratiometric to each other. Also, the sizes of MNB1 and MNB2 could either be equal or an integer ratio of each other. Note that alternate embodiments can use different bias generation circuits to generate Vnb and Vpb. For example, R1 can be implemented as a variable resistor so as to make the bias voltages programmable.

FIG. 3 illustrates a waveform representative of rst_ph, in accordance with one embodiment of the present invention. The signal rst_ph can be implemented as a digital clock signal which has a high phase corresponding to a reset phase 300 (in which rst_ph is a logic level high, i.e. logic level one) and a low phase corresponding to an amplification phase 302 (in which rst_ph is a logic level low, i.e. logic level zero). Therefore, rst_ph can be implemented as a periodic clock signal which alternates between the reset and amplification phases. Note that, in the illustrated embodiment, reset phase 300 is shorter in duration than amplification phase 302, however, in alternate embodiments, they may have the same duration. Operation of FIG. 1 below will be described in reference to rst_ph as illustrated in FIG. 3.

FIG. 4 illustrates, in schematic form, a Vcm generation circuit in accordance with an embodiment of the present invention, which includes a PMOS transistor 402 coupled in series with an NMOS transistor 404 between Vdd and Vss. A first current electrode of transistor 402 is coupled to Vdd, and a gate electrode and second current electrode of transistor 402 are coupled to a circuit node 406. A first current electrode of transistor 404 and a gate of transistor 404 are coupled to node 406, and a second current electrode of transistor 404 is coupled to Vss. Node 406 is the mid-node between transistors 402 and 404 and provides common mode voltage, Vcm. Note that alternate embodiments may include a different common mode generation circuit to provide Vcm.

Referring back to FIG. 1, in operation, during reset phase 300, switches 142, 144, 146, 148, 150, 152, and 154 are closed such that the gates of MP1 and MP2b are connected to Vpb while the gates of MN1 and MN2a are connected to Vnb. Also during reset, MP2a and MN2b are each diode-connected to self-bias using currents from MN2a and MP2b, respectively. This results in setting up all transistors in ring amplifier 100 at the bias points of the combination of the threshold voltage and the saturation voltage ("Vth+Vdsat"), giving each transistor an overdrive voltage set by the current. In the illustrated embodiment, the output of stage 102 at node 158 is also driven to Vcm (mid-rail) during reset if the reset time of ring amplifier 100 is insufficient for settling due to, e.g., the output resistance, Rout, of stage 102. Therefore, in an alternate embodiment, switch 150 may not be present and thus Vcm is not coupled to node 158 during the reset phase.

During amplification phase 302, Vin is capacitively coupled onto MP1 and MN1 via capacitors 114 and 116, respectively. The output of stage 102 at node 158 is then capacitively coupled onto each of the four transistors of stage 104 (on MP2a, MN2a, MP2b, and MN2b via capacitors 124, 126, 132, and 134, respectively). The difference between the average gate bias of the upper inverter of stage 102 (of MP2a/MN2a) and the lower inverter of stage 104 (of MP2b/MN2b) creates a dead-zone which stabilizes ring amplifier 100.

While ring amplifier 100 includes a chain of inverters, similar to a ring oscillator, the inverter chain is forked in stage 104 to the upper inverter (MP2a/MN2a) and the lower inverter (MP2b/MN2b), in which the upper inverter path shifts the signal at node 158 and the lower inverter path shifts the signal at node 158. This results in a voltage offset between the paths in which, under some conditions, node 172 can be at a higher potential than node 166. This offset voltage allows for fast slewing because, during initial response to an input, one of MP3, MN3 is off while the other has a large overdrive. It also allows for settling stability because, while the polse in the first stage (102) and the second stage (104) remain at high frequency, the output pole formed in the third stage (106) by MP3, MN3, and the output capacitance becomes a dominant pole. During the amplification phases, note that the voltage offsets for the dead-zone are stored across capacitors 124, 126, 132, and 134. Further, the PMOS and NMOS gates (inputs) of the inverter of stage 102 (the gates of MP1/MN1) and of each of the upper and lower inverters of stage 104 (the gates of MP2a/MN2a and MP2b/MN2b, respectively) are decoupled from each other and capacitively coupled to a corresponding input node (e.g. 156 and 158) via a corresponding capacitor such that the gates of each of MP1 and MN1 can be at different potentials, the gates of MP2a and MN2a can be at different potentials, and the gates of MP2b and MB2b can be at different potentials, whereas in traditional ring amplifiers, the PMOS and NMOS gates of each inverter in the first and second stages of the ring amplifier are typically tied together and thus at the same potential.

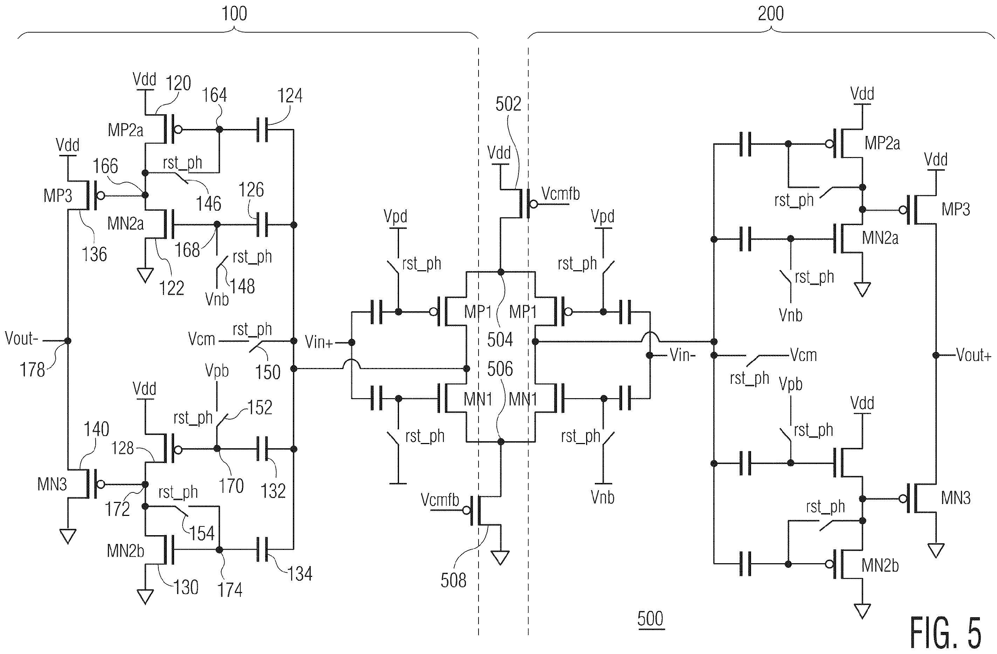

FIG. 5 illustrates, in schematic form, a differential ring amplifier 500 which may be implemented a ring amplifier such as ring amplifier 100 for each of the positive and negative sides of the differential ring amplifier. Ring amplifier 500 receives differential inputs Vin+ and Vin- and provides differential outputs Vout+ and Vout-. Therefore, ring amplifier 500 includes ring amplifier 100 on the left side of FIG. 5, in which Vin+ is received as Vin and Vout- is provided as Vout, and a ring amplifier 200 (which is a duplicate of ring amplifier 100) on the right side, in which Vin- is received as Vin and Vout+ is provided as Vout. Ring amplifier 500 may also includes a PMOS transistor 502 and an NMOS transistor 508. The first current electrodes of the MP1s of each of ring amplifiers 100 and 200 are connected at a circuit node 504 and the second current electrodes of the MN1s of each of ring amplifiers 100 and 200 are connected at a circuit node 506. Transistor 502 has a first current electrode coupled to Vdd, a second current electrode coupled circuit node 504, and a control electrode coupled to receive a common mode feedback voltage, Vcmfb. Transistor 508 has a first current electrode coupled to circuit node 506, a second current electrode coupled to Vss, and a control electrode coupled to receive Vcmfb. Each of ring amplifiers 100 and 200 operate as described above, and as a result, provide an amplified differential output during the amplification phase with a stabilized dead-zone.

Therefore, by now it can be understood how a ring oscillator with improved robustness over PVT variations has been provided in which the PMOS and NMOS gates of ring amplifier 100 can be dynamically biased independently, allowing them to vary as needed over PVT to maintain drive capability. This can be done by using the two bias voltages Vpb and Vnb, which are used to independently set bias points of the PMOS and NMOS transistors of stages 102 and 104. In one embodiment, as compared to traditional ring oscillators, the independent biasing allows for larger overdrives, up to nearly Vdd-Vth on every transistor, thus enabling the same drive capability with smaller transistors (at higher speeds) over PVT variations, including at the corners. Further, the independent biasing may reduce the variation of the drive capability of the amplifiers in stages 102 and 104. This may enable both faster slewing and more consistent stability and settling over PVT variation (in which the non-dominant poles remain at higher frequencies). This may prevent overdrives from becoming too small at lower supply voltages and higher Vth conditions (which may result in lowering speed, gain, and stability). Similarly, this may also prevent overdrives from becoming too large at higher supply voltages and lower Vth conditions (which may result in lowering gain and causing excessive current).

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a bar over the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed. Also, control electrodes of transistors can also be referred to as gates or gate electrodes, and current terminals of transistors can also be referred to as source/drains or source/drain electrodes.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Also for example, in one embodiment, the illustrated elements of ring oscillator 100 and bias generation circuit 200 are circuitry located on a single integrated circuit or within a same device. Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, the bias generation circuit may generate more than two bias circuits, such as a separate Vpb and separate Vnb for the first and second stages (stages 102 and 104). Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, a ring amplifier coupled to receive an input voltage and configured provide an output voltage, the ring oscillator includes a first inverter stage having a ring amplifier input node coupled to receive the input voltage and an output node; a second inverter stage; and a third inverter stage. The second inverter stage includes a first transistor of a first conductivity type having a first current electrode coupled to a first voltage supply terminal, a control electrode coupled via a first capacitor to the output node of the first inverter stage, and a second current electrode coupled to the control electrode of the first transistor via a first switch and to a first output node of the second inverter stage; a second transistor of a second conductivity type opposite the first conductivity type having a first current electrode coupled to the first output node of the second inverter stage, a second current electrode coupled to a second voltage supply terminal, and a control electrode coupled via a second capacitor to the output node of the first inverter stage and coupled to receive a first bias voltage via a second switch; a third transistor of the first conductivity type having a first current electrode coupled to the first voltage supply terminal, a second current electrode coupled to a second output node of the second inverter stage, and a control electrode coupled via a third capacitor to the output node of the first inverter stage and coupled to receive a second bias voltage via a third switch; and a fourth transistor of the second conductivity type having a first current electrode coupled to the second output node of the second inverter stage, a second current electrode coupled to the second voltage supply terminal, and a control electrode coupled via a fourth capacitor to the output node of the first inverter stage and coupled to the second current electrode of the fourth transistor via a fourth switch. The third inverter stage is coupled to the first and second output nodes of the second inverter stage and is configured to provide the output voltage at a ring amplifier output node. In one aspect of the embodiment, during a reset phase, the first, second, third, and fourth switches are each closed, and during an amplification phase, the first, second, third, and fourth switches are each open. In a further aspect, during the reset phase, the control electrode of the first transistor is directly connected to the second current electrode of the first transistor, the first bias voltage is provided to the control electrode of the second transistor, the second bias voltage is provided to the control electrode of the third transistor, and the first current electrode of the fourth transistor is directly connected to the control electrode of the fourth transistor. In another further aspect, during the amplification phase, the third inverter stage is configured to provide the output voltage as an amplified voltage of the input voltage. In yet another further aspect, each of the first, second, third, and fourth switches receive a reset phase control signal which has a first logic state during the reset phase and a second logic state during the amplification phase, wherein the first logic state causes each of the first, second, third, and fourth switches to be closed and the second logic state causes each of the first, second, third, and fourth switches to be open. In yet a further aspect, the reset phase control signal is implemented as a digital clock signal. In another further aspect, the ring amplifier further includes a fifth switch coupled between the output node of the first inverter stage and a common mode voltage, wherein the fifth switch is closed during the reset phase and open during the amplification phase. In another aspect of the above embodiment, the third inverter stage includes a fifth transistor of the first conductivity type having a first current electrode coupled to the first voltage supply terminal, a control electrode coupled to the first output node of the second inverter stage, and a second current electrode coupled to the ring amplifier output node; and a sixth transistor of the second conductivity type having a first current electrode coupled to the ring amplifier output node, a control electrode coupled to the second output node of the second inverter stage, and a second current electrode coupled to the second voltage supply terminal. In a further aspect, the ring amplifier further includes a fifth switch coupled between the output node of the first inverter stage and a common mode voltage, wherein the fifth switch is closed during a reset phase and open during an amplification phase. In another aspect of the above embodiment, the first bias voltage is generated by a first current generator and the second bias voltage is generated by a second current generator. In a further aspect, the first bias voltage is generated at a circuit node between a resistor and a fifth transistor of the second conductivity type of the first current generator, and the second bias voltage is generated at a circuit node between a diode-connected transistor of the first conductivity type and a sixth transistor of the second conductivity type. In a further aspect, control electrodes of the fifth and sixth transistors are connected, wherein the fifth transistor is configured to mirror a current to the sixth transistor.

In another embodiment, a ring amplifier coupled to receive an input voltage and configured provide an output voltage, the ring oscillator includes a first inverter stage, a second inverter stage, and a third inverter stage. The first inverter stage includes a first transistor of a first conductivity type having a first current electrode coupled to a first voltage supply terminal, a second current electrode coupled to an output node of the first inverter stage, and a control electrode coupled via a first switch to a first bias voltage and coupled via a first capacitor to a ring amplifier input node coupled to receive the input voltage; and a second transistor of a second conductivity type having a first current electrode coupled to the output node of the first inverter stage, a second current electrode coupled to a second voltage supply terminal, and a control electrode coupled via a second switch to a second bias voltage and coupled via a second capacitor to the ring amplifier input node. The second inverter stage includes a third transistor of the first conductivity type having a first current electrode coupled to the first voltage supply terminal, a control electrode coupled via a third capacitor to the output node of the first inverter stage, and a second current electrode coupled to the control electrode of the third transistor via a third switch and to a first output node of the second inverter stage; a fourth transistor of the second conductivity type opposite the first conductivity type having a first current electrode coupled to the first output node of the second inverter stage, a second current electrode coupled to the second voltage supply terminal, and a control electrode coupled via a fourth capacitor to the output node of the first inverter stage and coupled to receive the second bias voltage via a fourth switch; a fifth transistor of the first conductivity type having a first current electrode coupled to the first voltage supply terminal, a second current electrode coupled to a second output node of the second inverter stage, and a control electrode coupled via a fifth capacitor to the output node of the first inverter stage and coupled to receive the first bias voltage via a fifth switch; and a sixth transistor of the second conductivity type having a first current electrode coupled to the second output node of the second inverter stage, a second current electrode coupled to the second voltage supply terminal, and a control electrode coupled via a sixth capacitor to the output node of the first inverter stage and coupled to the second current electrode of the sixth transistor via a sixth switch. The third inverter stage is coupled to the first and second output nodes of the second inverter stage and is configured to provide the output voltage at a ring amplifier output node. In one aspect of the another embodiment, during a reset phase, the first, second, third, fourth, fifth, and sixth switches are each closed, and during an amplification phase, the first, second, third, fourth, fifth, and sixth switches are each open. In a further aspect, during the reset phase, the first bias voltage is provided to the control electrode of the first transistor, the second bias voltage is provided to the control electrode of the second transistor, the control electrode of the third transistor is directly connected to the second current electrode of the third transistor, the second bias voltage is provided to the control electrode of the fourth transistor, the first bias voltage is provided to the control electrode of the fifth transistor, and the first current electrode of the sixth transistor is directly connected to the control electrode of the sixth transistor. In another further aspect, during the amplification phase, the third inverter stage is configured to provide the output voltage at the ring amplifier output node as an amplified voltage of the input voltage. In another further aspect, each of the first, second, third, fourth, fifth, and sixth switches receive a reset phase control signal which has a first logic state during the reset phase and a second logic state during the amplification phase, wherein the first logic state causes each of the first, second, third, fourth, fifth, and sixth switches to be closed and the second logic state causes each of the first, second, third, fourth, fifth, and sixth switches to be open. In another aspect of the another embodiment, the third inverter stage includes a seventh transistor of the first conductivity type having a first current electrode coupled to the first voltage supply terminal, a control electrode coupled to the first output node of the second inverter stage, and a second current electrode coupled to the ring amplifier output node; and an eighth transistor of the second conductivity type having a first current electrode coupled to the ring amplifier output node, a control electrode coupled to the second output node of the second inverter stage, and a second current electrode coupled to the second voltage supply terminal. **In a** further aspect, the ring amplifier further includes a seventh switch coupled between the output node of the first inverter stage and a common mode voltage, wherein the seventh switch is closed during the reset phase and open during the amplification phase. **In** another aspect of the another embodiment, the second bias voltage is generated by a first current generator and the first bias voltage is generated by a second current generator, wherein the first current generator mirrors a current to the second current generator.

## Claims

1. A ring amplifier coupled to receive an input voltage and configured provide an output voltage, the ring oscillator comprising:
a first inverter stage having a ring amplifier input node coupled to receive the input voltage and an output node;
a second inverter stage comprising:
a first transistor of a first conductivity type having a first current electrode coupled to a first voltage supply terminal, a control electrode coupled via a first capacitor to the output node of the first inverter stage, and a second current electrode coupled to the control electrode of the first transistor via a first switch and to a first output node of the second inverter stage;
a second transistor of a second conductivity type opposite the first conductivity type having a first current electrode coupled to the first output node of the second inverter stage, a second current electrode coupled to a second voltage supply terminal, and a control electrode coupled via a second capacitor to the output node of the first inverter stage and coupled to receive a first bias voltage via a second switch;
a third transistor of the first conductivity type having a first current electrode coupled to the first voltage supply terminal, a second current electrode coupled to a second output node of the second inverter stage, and a control electrode coupled via a third capacitor to the output node of the first inverter stage and coupled to receive a second bias voltage via a third switch; and
a fourth transistor of the second conductivity type having a first current electrode coupled to the second output node of the second inverter stage, a second current electrode coupled to the second voltage supply terminal, and a control electrode coupled via a fourth capacitor to the output node of the first inverter stage and coupled to the second current electrode of the fourth transistor via a fourth switch; and
a third inverter stage coupled to the first and second output nodes of the second inverter stage and configured to provide the output voltage at a ring amplifier output node.

2. The ring amplifier of claim 1, wherein, during a reset phase, the first, second, third, and fourth switches are each closed, and during an amplification phase, the first, second, third, and fourth switches are each open.

3. The ring amplifier of claim 2, wherein, during the reset phase, the control electrode of the first transistor is directly connected to the second current electrode of the first transistor, the first bias voltage is provided to the control electrode of the second transistor, the second bias voltage is provided to the control electrode of the third transistor, and the first current electrode of the fourth transistor is directly connected to the control electrode of the fourth transistor.

4. The ring amplifier of claim 2 or 3, wherein, during the amplification phase, the third inverter stage is configured to provide the output voltage as an amplified voltage of the input voltage.

5. The ring amplifier of any of claims 2 to 4, wherein each of the first, second, third, and fourth switches receive a reset phase control signal which has a first logic state during the reset phase and a second logic state during the amplification phase, wherein the first logic state causes each of the first, second, third, and fourth switches to be closed and the second logic state causes each of the first, second, third, and fourth switches to be open.

6. The ring amplifier of claim 5, wherein the reset phase control signal is implemented as a digital clock signal.

7. The ring amplifier of any of claims 2 to 6, further comprising:
a fifth switch coupled between the output node of the first inverter stage and a common mode voltage, wherein the fifth switch is closed during the reset phase and open during the amplification phase.

8. The ring amplifier of any preceding claim, wherein the third inverter stage comprises:
a fifth transistor of the first conductivity type having a first current electrode coupled to the first voltage supply terminal, a control electrode coupled to the first output node of the second inverter stage, and a second current electrode coupled to the ring amplifier output node; and
a sixth transistor of the second conductivity type having a first current electrode coupled to the ring amplifier output node, a control electrode coupled to the second output node of the second inverter stage, and a second current electrode coupled to the second voltage supply terminal.

9. The ring amplifier of claim 8, further comprising:
a fifth switch coupled between the output node of the first inverter stage and a common mode voltage, wherein the fifth switch is closed during a reset phase and open during an amplification phase.

10. The ring amplifier of any preceding claim 1, wherein the first bias voltage is generated by a first current generator and the second bias voltage is generated by a second current generator.

11. The ring amplifier of claim 10, wherein the first bias voltage is generated at a circuit node between a resistor and a fifth transistor of the second conductivity type of the first current generator, and the second bias voltage is generated at a circuit node between a diode-connected transistor of the first conductivity type and a sixth transistor of the second conductivity type.

12. The ring amplifier of claim 11, wherein control electrodes of the fifth and sixth transistors are connected, wherein the fifth transistor is configured to mirror a current to the sixth transistor.
